# EUROPÄISCHE PATENTSCHRIFT

(11) **EP 0 842 493 B1**
(45) Veröffentlichungstag und Bekanntmachung des Hinweises auf die Patenterteilung: **01.07.2009**
(21) Anmeldenummer: 96921036.8
(22) Anmeldetag: 15.07.1996
(51) Int. Cl.: G06K 19/077

(54) **DATENTRÄGER MIT EINEM BAUTEIL AUFWEISENDEN MODUL UND MIT EINER SPULE UND VERFAHREN ZUM HERSTELLEN EINES SOLCHEN DATENTRÄGERS SOWIE MODUL HIERFÜR**
DATA CARRIER WITH A COMPONENT-CONTAINING MODULE AND WITH A COIL, METHOD OF PRODUCING SUCH A DATA CARRIER AND MODULE THEREFOR
SUPPORT DE DONNEES MUNI D'UN MODULE COMPORTANT UN COMPOSANT ET D'UNE BOBINE, PROCEDE DE PRODUCTION D'UN SUPPORT DE DONNEES DE CE TYPE ET MODULE APPROPRIE

(30) Priorität: 01.08.1995 AT 42295
(43) Veröffentlichungstag der Anmeldung: 20.05.1998
(73) Patentinhaber: Austria Card Plastikkarten und Ausweissysteme GmbH, 1232 Vienna (AT)
(72) Erfinder: PRANCZ, Markus, A-1200 Vienna (AT)
(74) Vertreter: Röggla, Harald
(86) Internationale Anmeldenummer: PCT/IB1996/000694
(87) Internationale Veröffentlichungsnummer: WO 1997/005571

(56) Entgegenhaltungen:
- EP-A- 0 595 549
- EP-A- 0 646 895
- EP-A- 0 671 705
- EP-A- 0 682 321
- DE-A- 4 337 921
- DE-A- 19 500 925
- DE-C- 4 403 753
- FR-A- 2 659 767

## Beschreibung

Die Erfindung bezieht sich auf einen Datenträger mit einem Datenträgerkörper, der von einer Körperfläche begrenzt ist und in den ein Modul und eine gegenüber dem Modul separate, Spulenwindungen und mindestens zwei Spulenanschlusskontakte aufweisende Spule aufgenommen ist, wobei der Modul einen plattenförmigen Träger, der im wesentlichen parallel zu der besagten Körperfläche verläuft und der von einer der besagten Körperfläche zugewandten ersten Trägerhauptfläche und von einer von der besagten Körperfläche abgewandten und zu der ersten Trägerhauptfläche im wesentlichen parallelen zweiten Trägerhauptfläche begrenzt ist, und mindestens einen Bauteil, der in den Datenträgerkörper aufgenommen und mit dem Träger verbunden und gegenüber der zweiten Trägerhauptfläche erhaben ist und der in einem sich quer zu der besagten Körperfläche erstreckenden Bauteilniveaubereich liegt, und mindestens zwei Modulanschlusskontakte aufweist, die mit dem Träger verbunden und in dem Bereich der zweiten Trägerhauptfläche vorgesehen sind, und wobei die Spulenwindungen der Spule zumindest in ihrem zu dem Bauteil benachbarten Bereich in einem sich quer zu der besagten Körperfläche erstreckenden, außerhalb des Bauteilniveaubereiches liegenden Windungsniveaubereich liegen und die Spulenanschlusskontakte gemeinsam mit den Spulenwindungen der Spule in dem Windungsniveaubereich liegen und wobei jeder Spulenanschlusskontakt in einer quer zu der zweiten Trägerhauptfläche verlaufenden Richtung einem Modulanschlusskontakt gegenüberliegt und mit letzterem in elektrisch leitender Verbindung steht und wobei die Modulanschlusskontakte den Bauteil niveaumäßig überragen und durch den Bauteilniveaubereich hindurch bis zu den in dem Windungsniveaubereich liegenden Spulenanschlusskontakten reichen und wobei der Datenträgerkörper eine Ausnehmung aufweist, die in die besagte Körperfläche mündet und in die der Modul eingesetzt ist.

Weiters bezieht sich die Erfindung auf ein Verfahren zum Herstellen einer Datenträgers, bei dem ein Datenträgerkörper hergestellt wird, der von einer Körperfläche begrenzt ist, und bei dem beim Herstellen des Datenträgerkörpers eine Spule, die Spulenwindungen und mindestens zwei Spulenanschlusskontakte aufweist, in den Datenträgerkörper aufgenommen wird, wobei die Spulenwindungen zumindest in ihrem zu dem Bauteil benachbarten Bereich in einem sich quer zu der besagten Körperfläche erstreckenden, außerhalb des Bauteilniveaubereiches liegenden Windungsniveaubereich zu liegen kommen, und bei dem in den Datenträgerkörper ein Modul aufgenommen wird, der einen plattenförmigen, von einer ersten Trägerhauptfläche und von einer zu der ersten Trägerhauptfläche im wesentlichen parallelen zweiten Trägerhauptfläche begrenzten Träger und einen mit dem Träger verbundenen, gegenüber der zweiten Trägerhauptfläche erhabenen Bauteil und mindestens zwei mit dem Träger verbundene, im Bereich der zweiten Trägerhauptfläche vorgesehene Modulanschlusskontakte aufweist, wobei die erste Trägerhauptfläche der besagten Körperfläche zugewandt und die zweite Trägerhauptfläche von der besagten Körperfläche abgewandt zu liegen kommen und wobei der Bauteil in einem sich quer zu der besagten Körperfläche erstreckenden Bauteilniveaubereich zu liegen kommt, und bei dem je ein Modulanschlusskontakt und je ein Spulenanschlusskontakt in einer quer zu der zweiten Trägerhauptfläche verlaufenden Richtung einander gegenüberliegend zu liegen kommen und in elektrisch leitende Verbindung gebracht werden, und bei dem zum Aufnehmen in den Datenträgerkörper ein Modul verwendet wird, bei dem die Modulanschlusskontakte den Bauteil des Moduls niveaumäßig überragen, und bei dem die Modulanschlusskontakte durch den Bauteilniveaubereich hindurch bis zu den in dem Windungsniveaubereich liegenden Spulenanschlusskontakten gebracht werden und mit den Spulenanschlusskontakten in elektrisch leitende Verbindung gesetzt werden und bei dem in dem Datenträgerkörper eine Ausnehmung hergestellt wird, die in die besagte Körperfläche mündet.

Ein solcher als Chipkarte ausgebildeter Datenträger gemäß der vorstehend im ersten Absatz angeführten Gattung und ein Verfahren gemäß der vorstehend im zweiten Absatz angeführten Gattung sind beispielsweise aus dem Dokument EP 0 671 705 A2 bekannt.

In dem Dokument EP 0 671 705 A2 ist in den Figuren 5 und 7 je eine mit einem eingebetteten elektronischen Modul versehene Chipkarte offenbart. Die Chipkarte wird in mehreren Schritten hergestellt. Die Chipkarte weist einen Datenträgerkörper auf, der ebenso in mehreren Schritten hergestellt wird. Und zwar wird auf einer aus einem thermoplastischen Kunststoff bestehenden Basisfolie eine Spule angebracht. Danach wird auf der aus der Basisfolie und der Spule bestehenden Baueinheit ein Kartenoberteil angebracht, der aus einem die Spule überdeckenden und in einem Spritzgussvorgang mit der Basisfolie verbundenen Kunststoff-Abdeckkörper besteht. Bei dem Spritzgussvorgang wird eine Form mit mehreren Kernen verwendet. Ein Kern ist dabei zum Bilden einer Ausnehmung zum Aufnehmen des Moduls vorgesehen. Zwei weitere Kerne sind zum Bilden von zwei von der Ausnehmung bis zu den Spulenanschlusskontakten reichenden Zugängen vorgesehen. Auf diese Weise ist erreicht, dass unmittelbar nach dem Spritzgussvorgang, also unmittelbar nach Erhalt des mit der Ausnehmung versehenen Datenträgerkörpers, die Spulenanschlusskontakte zumindest mit einem Großteil ihrer zum elektrischen Verbinden mit den Modulanschlusskontakten vorgesehenen Kontaktflächen frei zugänglich sind und daher nach Erhalt des Datenträgerkörpers ohne zusätzliche Maßnahmen gegebenenfalls über zusätzlich einzubringende elektrisch leitfähige Verbindungsmittel unmittelbar mit den Modulanschlusskontakten verbindbar sind. Chipkarten, deren Datenträgerkörper aus einer Basisfolie und aus einem Kunststoff-Abdeckkörper bestehen, weisen diverse Nachteile auf, beispielsweise dass sie zum Verwerfen bzw. Verbiegen neigen, sind relativ aufwendig herzustellen und sind für einige Anwendungsfälle nicht geeignet, wodurch ihre Anwendbarkeit eingeschränkt ist. Mit dem bekannten Verfahren sind sämtliche Verfahrensschritte immer nur für das Herstellen einer einzigen Chipkarte geeignet, was eine relativ lange Herstellungsdauer zur Folge hat. Weiters ist bei dem bekannten Verfahren ein relativ aufwendiges Spritzwerkzeug erforderlich, was im Hinblick auf möglichst geringe Werkzeugkosten und Herstellungskosten ungünstig ist.

Die Erfindung hat sich zur Aufgabe gestellt, bei einem Datenträger entsprechend der eingangs im ersten Absatz angeführten Gattung die vorstehend angeführte Einschränkung zu vermeiden und einen verbesserten Datenträger zu schaffen. Zur Lösung dieser Aufgabe ist bei einem Datenträger entsprechend der eingangs im ersten Absatz angeführten Gattung gemäß der Erfindung vorgesehen, dass der Datenträgerkörper aus mindestens zwei Folien mit einem Laminierverfahren hergestellt ist und dass eine durch ein Materialabtragungsverfahren hergestellte Ausnehmung vorgesehen ist und dass in einem von der besagten Körperfläche abgewandten Bodenbereich der Ausnehmung mindestens zwei ebenso durch ein, vorzugsweise dasselbe Materialabtragungsverfahren hergestellte, von dem Bodenbereich der Ausnehmung bis zu den Spulenanschlusskontakten reichende Zugänge vorgesehen sind, durch die hindurch die Modulanschlusskontakte mit den Spulenanschlusskontakten in elektrisch leitender Verbindung stehen. Eine solche Ausbildung hat sich im Hinblick auf eine sehr preiswerte Herstellbarkeit als sehr günstig erwiesen. Weiters ist auf diese Weise ein Datenträger mit einem in einem Laminiervorgang hergestellten Datenträgerkörper erhalten, in dem eine durch ein Materialabtragungsverfahren hergestellte Ausnehmung zum Aufnehmen eines Moduls vorgesehen ist, von der im Bodenbereich derselben zwei ebenso durch ein Materialabtragungsverfahren, vorzugsweise durch dasselbe Materialabtragungsverfahren, hergestellte Zugänge zu den Spulenanschlusskontakten vorgesehen sind, wodurch der bedeutende Vorteil erhalten ist, dass die von dem Bodenbereich ausgehenden Zugänge nur eine geringe Tiefe aufweisen, so dass ihre Herstellung nur einen kurzen Materialabtragungsvorgang erfordern und dass aufgrund der geringen Tiefe eine stets sichere elektrisch leitfähige Verbindung zwischen den Modulanschlusskontakten und den Spulenanschlusskontakten erreichbar und gewährleistet ist.

Es kann erwähnt werden, dass aus dem Patentdokument US 5 519 201 A ein Datenträger bekannt ist, bei welchem Datenträger der Datenträgerkörper mit einem Laminierverfahren hergestellt ist und der Datenträgerkörper eine Ausnehmung aufweist, in die ein Modul eingesetzt ist, der erstens einen Träger mit einer ersten Trägerhauptfläche und mit einer zweiten Trägerhauptfläche und zweitens einen an dem Träger in dem Bereich der zweiten Trägerhauptfläche angebrachten Bauteil und drittens zwei durch je eine dünne flache Leiterbahn gebildete und folglich den Bauteil niveaumäßig bei weitem nicht überragende Modulanschlusskontakte aufweist, wobei die Ausnehmung mit einem Bodenbereich und mit einem Schulterbereich begrenzt ist und der Modul mit seinem Träger auf dem Schulterbereich aufliegt. Bei dem bekannten Datenträger liegt jeder der zwei Spulenanschlusskontakte in einer quer zu den zwei Trägerhauptflächen verlaufenden Richtung dem Schulterbereich und einem Modulanschlusskontakt gegenüber und sind im Gegensatz zu dem Datenträger gemäß der Erfindung, bei dem in dem Bodenbereich zwei relativ kurze Zugänge vorgesehen sind, in dem Schulterbereich zwei relativ lange Durchgänge vorgesehen, die von den zwei Modulanschlusskontakten bis zu den zwei Spulenanschlusskontakten reichen. Bei dem bekannten Datenträger sind im Gegensatz zu dem Datenträger gemäß der Erfindung, bei dem die leitenden Verbindungen zwischen den Modulanschlusskontakten und den Spulenanschlusskontakten mit den ohnehin vorhandenen und auf vorteilhafte Weise den Bauteil niveaumäßig überragenden Modulanschlusskontakten realisiert sind, mit Hilfe von zwei separaten zylindrischen Verbindungsteilen realisiert, die je in einen der zwei Durchgänge eingesetzt sind. Die Notwendigkeit von zwei separaten Verbindungsteilen stellt einen Mehraufwand hinsichtlich Materialkosten und Montagekosten dar.

In dem Dokument EP 0 682 321 A2 sind ebenfalls Datenträger, nämlich Chipkarten beschrieben. Diese Chipkarten weisen einen Datenträgerkörper auf, der aus einer Mehrzahl von miteinander laminierten Folien gebildet ist, wobei aber zur Bildung einer Ausnehmung für die Aufnahme eines Moduls bzw. eines elektronischen Bauteils in den betreffenden Folien entsprechende Öffnungen vor dem Laminiervorgang angebracht werden, so dass in separaten Folien je eine Öffnung angebracht werden muss und das Stapeln der Folien vor dem Laminieren mit hoher Präzision erfolgen muss, um eine genaue Ausrichtung der Öffnungen zueinander sicherzustellen und dadurch eine einwandfrei ausgebildete Ausnehmung zu gewährleisten. Dies stellt ein relativ aufwendiges Herstellungsverfahren dar.

Bei einem wie vorstehend angeführten erfindungsgemäßen Datenträger hat sich als besonders vorteilhaft erwiesen, wenn die Ausnehmung und die Zugänge zu den Spulenanschlusskontakten durch einen Fräsvorgang hergestellt sind. Dies ist im Hinblick auf eine hochpräzise Herstellbarkeit der zum Aufnehmen des Moduls vorgesehenen Ausnehmung und der Zugänge zu den Spulenanschlusskontakten besonders vorteilhaft.

Bei einem erfindungsgemäßen Datenträger mit einer Ausnehmung und mit im Bodenbereich der Ausnehmung vorgesehenen Zugängen zu den Spulenanschlusskontakten können die durch die Zugänge hindurch mit den Spulenanschlusskontakten in elektrisch leitender Verbindung stehenden Modulanschlusskontakte elastisch nachgiebig ausgebildet sein und ausschließlich auf Basis ihrer elastischen Nachgiebigkeit mit den Spulenanschlusskontakten in elektrisch leitender Verbindung stehen. Als besonders vorteilhaft hat sich aber erwiesen, wenn in den Zugängen ein elektrisch leitendes Klebemittel vorgesehen ist, mit dem die Modulanschlusskontakte und die Spulenanschlusskontakte elektrisch leitend miteinander verbunden sind. Auf diese Weise ist eine besonders sichere elektrische Verbindung zwischen den Spulenanschlusskontakten und den Modulanschlusskontakten erreicht.

Bei einem erfindungsgemäßen Datenträger, bei dem die Spulenanschlusskontakte gemeinsam mit den Spulenwindungen der Spule in dem Windungsniveaubereich liegen, hat sich weiters als besonders vorteilhaft erwiesen, wenn die Spulenwindungen und die Spulenanschlusskontakte der Spule durch mit einem Siebdruckverfahren hergestellte Leiterbahnen gebildet sind. Auf diese Weise sind die Vorteile von Siebdruckverfahren, deren Anwendung bei der Herstellung von Spulen für Datenträger an sich bekannt ist, auch bei einem erfindungsgemäßen Datenträger vorteilhafterweise ausgenützt.

Im vorstehend angeführten Zusammenhang hat sich weiters als sehr vorteilhaft erwiesen, wenn die Spulenwindungen und die Spulenanschlusskontakte der Spule durch mit einem Siebdruckverfahren unter Verwendung einer Silberleitpaste hergestellte Leiterbahnen gebildet sind. Dies erweist sich in der Praxis als besonders günstig.

Bei einem erfindungsgemäßen Datenträger, bei dem ein einen Bauteil tragender Modul in eine in eine Körperfläche des Datenträgerkörpers mündende Ausnehmung eingesetzt ist, wobei dann die erste Trägerhauptfläche des Trägers des Moduls üblicherweise von außerhalb des Datenträgers sowohl mechanisch abtastbar als auch visuell wahrnehmbar ist, kann die erste Trägerhauptfläche des Trägers des Moduls zur Erzielung eines optischen Effektes mit einer Bedruckung versehen sein. Es kann aber auch sehr vorteilhaft sein, wenn mit dem Träger des Moduls im Bereich seiner ersten Trägerhauptfläche vorgesehene weitere Modulanschlusskontakte verbunden sind, die zum Zusammenwirken mit von außerhalb des Datenträgers mit ihnen in Kontaktverbindung bringbaren Gegenkontakten ausgebildet sind. Auf diese Weise ist erreicht, dass in einem solchen Datenträger als Bauteil ein sogenannter Doppel-Zweck-Chip zum Einsatz kommen kann, dessen im Bereich der zweiten Trägerhauptfläche vorgesehene Modulanschlusskontakte mit den Spulenanschlusskontakten einer Spule verbunden sind, die zum berührungslosen Datenaustausch zwischen dem Doppel-Zweck-Chip und einer Schreib/Lese-Station und gegebenenfalls zur berührungslosen Energieübertragung zu dem Doppel-Zweck-Chip vorgesehen ist, und dessen im Bereich der ersten Trägerhauptfläche vorgesehene weitere Modulanschlusskontakte zum kontaktbehafteten Datenaustausch zwischen dem Doppel-Zweck-Chip und einer Schreib/Lese-Station und zur kontaktbehafteten Energieübertragung zu dem Doppel-Zweck-Chip vorgesehen sind.

Erfindungsgemäße Datenträger können unterschiedlichen Zwecken dienen und verschiedene Formen aufweisen, beispielsweise eine Schlüsselform, eine Stabform und andere Formen. In diesem Zusammenhang ist noch ausdrücklich festzustellen, dass bei diesen Formen von erfindungsgemäßen Datenträgern unter der besagten Körperfläche nicht unbedingt die flächenmäßig größte Körperbegrenzungsfläche zu verstehen ist. Bei einer Stabform kann die im vorliegenden Zusammenhang die besagte Körperfläche darstellende Körperbegrenzungsfläche durch eine Stirnfläche des stabförmigen Datenträgers gebildet sein. Dies gilt ebenso für einen schlüsselförmigen Datenträger und auch andersförmige Datenträger. Eine besonders bevorzugte Variante eines erfindungsgemäßen Datenträgers ist dadurch gekennzeichnet, dass der Datenträger als Chipkarte ausgebildet ist.

Ein Verfahren gemäß der eingangs im zweiten Absatz angeführten Gattung ist gemäß der Erfindung dadurch gekennzeichnet, dass beim Herstellen des Datenträgerkörpers die Spulenwindungen und die Spulenanschlusskontakte der Spule auf eine Trägerfolie aufgebracht werden und dass danach die Trägerfolie mit den auf ihr aufgebrachten Spulenwindungen und Spulenanschlusskontakten der Spule mit mindestens einer weiteren Folie gestapelt wird, wobei die Spulenwindungen und die Spulenanschlusskontakte der Spule zwischen der Trägerfolie und einer Deckfolie zu liegen kommen, und dass danach die gestapelten Folien durch einen Laminiervorgang zum Herstellen des Datenträgerkörpers laminiert werden und dass danach in dem hergestellten Datenträgerkörper mit einem Materialabtragungsverfahren die Ausnehmung hergestellt wird und dass in einem von der besagten Körperfläche abgewandten Bodenbereich der Ausnehmung ebenso durch ein, vorzugsweise dasselbe Materialabtragungsverfahren mindestens zwei von dem Bodenbereich der Ausnehmung bis zu den Spulenanschlusskontakten reichende Zugänge hergestellt werden, und dass der Modul mit dem Bauteil und den Modulanschlusskontakten voran in die Ausnehmung eingesetzt wird und dass die Modulanschlusskontakte durch die Zugänge hindurch mit den Spulenanschlusskontakten in elektrisch leitende Verbindung gesetzt werden. Ein solches Verfahren hat sich im Hinblick auf ein sehr preiswertes Herstellen eines Datenträgers als sehr günstig erwiesen.

Im Hinblick auf die Materialabtragung zum Herstellen der Ausnehmung und der Zugänge hat sich als besonders vorteilhaft erwiesen, wenn die Materialabtragung zum Herstellen der Ausnehmung und der Zugänge zu den Spulenanschlusskontakten durch einen Fräsvorgang erfolgt. Auf diese Weise kann ein relativ großes Volumen an Material sehr schnell und sehr präzise abgetragen werden, wobei Toleranzen von nur einigen Mikrometern eingehalten werden können.

Bei einem erfindungsgemäßen Verfahren, bei dem in einem hergestellten Datenträgerkörper eine Ausnehmung und im Bodenbereich der Ausnehmung Zugänge zu den Spulenanschlusskontakten hergestellt werden, hat sich als besonders vorteilhaft erwiesen, wenn vor dem Einsetzen des Moduls in die Ausnehmung durch die Ausnehmung und durch die Zugänge hindurch mit den Spulenanschlusskontakten eine Prüfeinrichtung zum Prüfen der einwandfreien Funktionstüchtigkeit der Spule in Wirkverbindung gebracht wird. Hierdurch ist vorteilhafterweise erreicht, dass im Zuge des Herstellens eines Datenträgers die Spulenanschlusskontakte von außen her durch die Ausnehmung und die Zugänge hindurch zugänglich gemacht werden, so dass mit den Spulenanschlusskontakten die Anschlusskontakte einer Prüfeinrichtung in elektrisch leitende Verbindung bringbar sind und somit prüfbar ist, ob die in einem Datenträgerkörper aufgenommene und darin eingebettete Spule einwandfrei funktionstüchtig ist. Erst nach Erhalt eines positiven Prüfungsergebnisses wird der in Relation zu den übrigen Datenträgerbestandteilen teure Modul in den Datenträgerkörper eingesetzt. Hingegen wird bei einem negativen Prüfungsergebnis der Datenträgerkörper samt der darin eingebetteten defekten Spule, aber ohne eingesetzten Modul ausgeschieden, so dass kein Modul unnütz vergeudet wird, was im Hinblick auf möglichst geringe Ausschusskosten und folglich im Hinblick auf ein möglichst kostengünstiges Herstellen eines Datenträgers äußerst vorteilhaft ist.

Im Hinblick auf ein einwandfreies Herstellen von leitenden Verbindungen zwischen den Modulanschlusskontakten und den Spulenanschlusskontakten hat sich als vorteilhaft erwiesen, wenn vor dem Einsetzen des Moduls in die Ausnehmung in die Zugänge ein elektrisch leitendes Klebemittel eingebracht wird. Auf diese Weise werden besonders gute und sichere sowie alterungsbeständige leitende Verbindungen zwischen den Modulanschlusskontakten und den Spulenanschlusskontakten gebildet.

Als sehr vorteilhaft hat sich weiters erwiesen, wenn vor dem Einsetzen des Moduls in die Ausnehmung in einem Randbereich der zweiten Trägerhauptfläche des Trägers des Moduls ein Heißschmelz-Klebemittel aufgetragen wird und wenn nach dem Einsetzen des Moduls in die Ausnehmung auf die erste Trägerhauptfläche des Trägers des Moduls ein Heizstempel einer Heizvorrichtung zum Aktivieren des Heißschmelz-Klebemittels aufgesetzt wird. Dies ist hinsichtlich eines einfachen und sicheren Festhaltens des Moduls mittels seines Trägers an dem Datenträgerkörper vorteilhaft.

Auch hat sich als besonders vorteilhaft erweisen, wenn als Trägerfolie, auf welche die Spulenwindungen und die Spulenanschlusskontakte der Spule aufgebracht werden, eine aus Polycarbonat bestehende Folie verwendet wird. Eine solche Folie aus Polycarbonat hat sich in der Praxis als besonders vorteilhaft erwiesen, weil beim Laminiervorgang die Spule samt ihren Spulenanschlusskontakten in eine solche Folie gleichmäßig eingedrückt wird und folglich die Spule samt ihren Spulenanschlusskontakten praktisch ohne mechanische Belastungen und Spannungen im fertiggestellten Datenträgerkörper eingebettet ist.

Hierbei hat sich weiters als sehr vorteilhaft erwiesen, wenn als Deckfolie, die beim Stapeln der Folien den Spulenwindungen und den Spulenanschlusskontakten der Spule unmittelbar gegenüberliegt, eine aus Polyvinylchlorid bestehende Folie verwendet wird. Mit einer solchen Folie aus Polyvinylchlorid als Deckfolie wird das gleichmäßige Eindrücken und Einbetten der Spule günstig unterstützt.

Hierbei hat sich weiters auch noch als sehr vorteilhaft erwiesen, wenn die Spulenwindungen und die Spulenanschlusskontakte der Spule durch Aufbringen eines leitfähigen Materials auf die Trägerfolie in einem Siebdruckvorgang hergestellt werden. Auf diese Weise sind die Vorteile von Siebdruckverfahren, deren Anwendung zum Herstellen von Spulen für Datenträger an sich bekannt ist, auch bei einem erfindungsgemäßen Verfahren vorteilhafterweise ausgenützt.

Im vorstehend angeführten Zusammenhang hat sich weiters als sehr vorteilhaft erwiesen, wenn die Spulenwindungen und die Spulenanschlusskontakte der Spule durch Aufbringen einer Silberleitpaste auf die Trägerfolie in einem Siebdruckvorgang hergestellt werden. Dies erweist sich in der Praxis als besonders günstig.

Die vorstehend angeführten Aspekte und weitere Aspekte der Erfindung gehen aus den nachfolgend beschriebenen Ausführungsbeispielen hervor und sind anhand dieser Ausführungsbeispiele erläutert.

Die Erfindung wird im folgenden anhand von zwei in den Zeichnungen dargestellten Ausführungsbeispielen weiter erläutert, auf welche die Erfindung aber nicht beschränkt ist.

Die Figur 1 zeigt in einem Querschnitt gemäß der Linie I-I in der Figur 2 einen Teil einer großflächigen Trägerfolie, auf der eine Vielzahl von Spulen angebracht sind, von denen nur eine Spule mit ihren Spulenwindungen und mit ihren beiden Spulenanschlusskontakten dargestellt ist.

Die Figur 2 zeigt in einem Schnitt gemäß der Linie II-II in der Figur 1 eine auf die großflächige Trägerfolie aufgebrachte Spule mit ihren Spulenwindungen und mit ihren beiden Spulenanschlusskontakten.

Die Figur 3 zeigt analog wie die Figur 1 einen Folienstapel, der aus insgesamt sechs großflächigen Folien besteht und der die großflächige Trägerfolie gemäß der Figur 1 enthält.

Die Figur 4 zeigt analog wie die Figuren 1 und 3 einen großflächigen Folienkörper, der durch Laminieren des Folienstapels gemäß der Figur 3 erhalten wird und in den eine Vielzahl von Spulen samt ihren Spulenanschlusskontakten eingebettet sind.

Die Figur 5 zeigt analog wie die Figuren 1, 3 und 4 einen Kartenkörper einer Chipkarte, der durch Ausstanzen aus dem Folienkörper gemäß der Figur 4 erhalten wird und in den eine Spule samt ihren beiden Spulenanschlusskontakten eingebettet ist.

Die Figur 6 zeigt analog wie die Figuren 1, 3 , 4 und 5 den Kartenkörper gemäß der Figur 5, der eine Ausnehmung und zwei von der Ausnehmung bis zu den beiden Spulenanschlusskontakten reichende Zugänge aufweist.

Die Figur 7 zeigt analog wie die Figuren 1, 3, 4, 5 und 6 den Kartenkörper gemäß der Figur 6, wobei in die Zugänge ein elektrisch leitendes Klebemittel eingebracht ist und ein Modul sich über der Ausnehmung in dem Kartenkörper befindet.

Die Figur 8 zeigt analog wie die Figuren 1, 3, 4, 5, 6 und 7 eine fertiggestellte Chipkarte als Datenträger gemäß einem ersten Ausführungsbeispiel der Erfindung, bei der in die Ausnehmung ihres Kartenkörpers ein Modul eingesetzt ist.

Die Figur 9 zeigt analog wie die Figur 8, jedoch ausschnittsweise und in einem gegenüber der Figur 8 etwa vierfach größeren Maßstab die fertiggestellte Chipkarte mit dem in die Ausnehmung eingesetzten Modul, wobei zwei Modulanschlusskontakte und die beiden Spulenanschlusskontakte mit einem elektrisch leitenden Klebemittel elektrisch leitend miteinander verbunden sind.

Die Figur 10 zeigt analog wie die Figur 9 eine fertiggestellte Chipkarte als Datenträger gemäß einem zweiten Ausführungsbeispiel der Erfindung, die einen ebenfalls in einer Laminiertechnik hergestellten Kartenkörper aufweist und bei der zwei Modulanschlusskontakte elastisch nachgiebig ausgebildet sind und ausschließlich auf Basis ihrer elastischen Nachgiebigkeit mit zwei Spulenanschlusskontakten in elektrisch leitender Kontaktverbindung stehen.

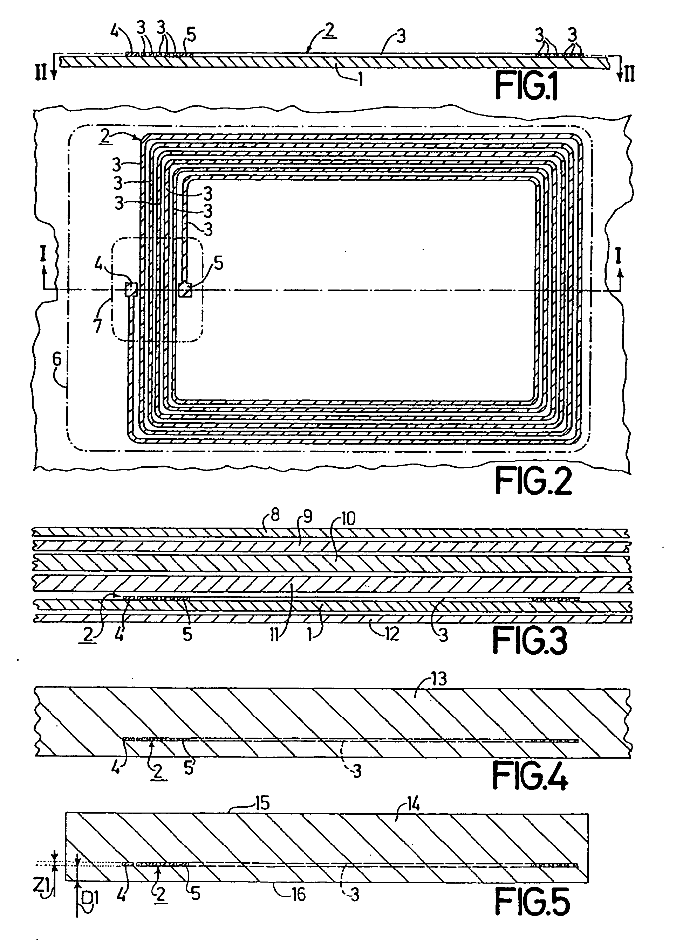

Nachfolgend wird vorerst anhand der Figuren 1 bis 8 eine mögliche Variante eines erfindungsgemäßen Verfahrens zum Herstellen eines erfindungsgemäßen Datenträgers beschrieben, der als Chipkarte ausgebildet ist.

Bei einem ersten Verfahrensschritt wird eine in der Figur 1 dargestellte großflächige Trägerfolie 1 einer Siebdruckeinrichtung zugeführt. Die Trägerfolie 1 weist eine Flächenabmessung von 530 mm x 660 mm auf. Die Dicke der Trägerfolie 1 beträgt etwa 125 µm. Die Trägerfolie 1 besteht aus Polycarbonat, was sich bei dem hier beschriebenen Verfahren als sehr vorteilhaft erwiesen hat.

In einem nachfolgenden Verfahrensschritt werden in der Siebdruckeinrichtung in einer Siebdrucktechnik durch Aufbringen eines leitfähigen Materials, im vorliegenden Fall durch Aufbringen einer Silberleitpaste, auf die Trägerfolie 1 eine Mehrzahl von Spulen 2 aufgebracht, die im vorliegenden Fall je insgesamt sechs durch Leiterbahnen gebildete Spulenwindungen 3 aufweisen. Es sei erwähnt, dass die Anzahl und die Form der Spulenwindungen 3 der Spulen 2 auch anders gewählt sein können. Im vorliegenden Fall werden zugleich achtundvierzig Spulen auf die großflächige Trägerfolie 1 aufgebracht, von denen in den Figuren 1 und 2 aber nur eine Spule 2 dargestellt ist. Am freien Ende der äußersten Spulenwindung und am freien Ende der innersten Spulenwindung jeder Spule 2 ist je ein rechteckförmiger Spulenanschlusskontakt 4 bzw. 5 vorgesehen. Die beiden Spulenanschlusskontakte 4 und 5 sind ebenfalls durch Leiterbahnen gebildet, die analog wie die Spulenwindungen 3 auf die Trägerfolie 1 aufgebracht werden. Die Dicke der Spulenwindungen 3 bzw. der Spulenanschlusskontakte 4 und 5 der Spule 2 beträgt etwa 25 µm. Um diese Dicke mittels einer üblichen Siebdrucktechnik zu erreichen, können auch mehrere Druckvorgänge durchgeführt werden, wobei bei jedem nachfolgenden Druckvorgang Silberleitpaste auf die beim jeweils vorherigen Druckvorgang aufgebrachte Silberleitpaste aufgetragen wird, so dass durch das mehrmalig übereinander erfolgende Auftragen von Silberleitpaste in einem Siebdruckvorgang die gewünschte Höhe der Spulenwindungen 3 und der beiden Spulenanschlusskontakte 4 und 5 der Spule 2 erreicht werden.

Durch das vorstehend erläuterte Aufbringen der Spulen 2 auf die Trägerfolie 1 wird das in den Figuren 1 und 2 dargestellte Zwischenprodukt erhalten.

Bezüglich der Figur 2 ist noch zu erwähnen, dass in derselben mit einer strichpunktierten Linie 6 die Umrisskontur einer herzustellenden Chipkarte und mit einer weiteren strichpunktierten Linie 7 die Umrisskontur eines Trägers eines einen Chip als Bauteil enthaltenden Moduls dargestellt sind.

Bei einem nächsten Verfahrensschritt wird - wie dies in der Figur 3 schematisch dargestellt ist - die großflächige Trägerfolie 1 mit den auf ihr aufgebrachten Spulen 2 mit insgesamt im vorliegenden Fall fünf weiteren Folien 8, 9, 10, 11 und 12 gestapelt, wobei die Spulen 2 und somit auch ihre Spulenanschlusskontakte 4 und 5 zwischen der Trägerfolie 1 und einer Deckfolie 11 zu liegen kommen. Bezüglich der Deckfolie 11 ist zu erwähnen, dass es sich hierbei um eine Folie aus Polyvinylchlorid handelt, die eine Dicke von etwa 200 µm aufweist. Die Flächenabmessungen der weiteren Folien 8, 9, 10, 11 und 12 stimmen mit der Flächenabmessung der Trägerfolie 1 nominal überein.

Bezüglich der Folie 12, die an der von den Spulen 2 abgewandten Flächenseite der Trägerfolie 1 liegt, ist noch zu erwähnen, dass es sich hierbei ebenfalls um eine Folie aus Polyvinylchlorid handelt, die aber eine Dicke von nur etwa 100 µm aufweist. Die Folie 8 besteht ebenso wie die Folie 12 aus Polyvinylchlorid und weist ebenso wie die Folie 12 eine Dicke von etwa 100 µm auf. Die Folie 9 besteht ebenso wie die Trägerfolie 1 aus Polycarbonat und weist ebenso wie die Trägerfolie 1 eine Dicke von etwa 125 µm auf. Die Folie 10 besteht ebenso wie die Folie 11 aus Polyvinylchlorid und weist ebenso wie die Folie 11 eine Dicke von etwa 200 µm auf.

Nach dem wie aus der Figur 3 ersichtlichen Stapeln der Folien 8, 9, 10, 11, 1 und 12 werden in einem nächsten Verfahrensschritt die gestapelten Folien durch einen Laminiervorgang laminiert. Bei diesem Laminiervorgang werden die Folien 8, 9, 10, 11, 1 und 12 unter Einwirkung von Druck und Hitze miteinander verbunden, wobei durch ein kontrolliertes Verschmelzen der einzelnen Folien miteinander ein sogenanntes Homogenisieren der Folien erfolgt, so dass ein großflächiger Folienkörper 13 erhalten wird, wie dieser in der Figur 4 dargestellt ist. In dem großflächigen Folienkörper 13 mit den Flächenabmessungen von 530 mm x 660 mm sind eine Mehrzahl von Spulen 2 eingebettet, wie dies für eine Spule 2 in der Figur 4 dargestellt ist.

In einem nachfolgenden Verfahrensschritt werden mit einem Stanzwerkzeug in einem Stanzvorgang aus dem großflächigen Folienkörper 13 eine Mehrzahl von als Datenträgerkörper anzusehenden Kartenkörpern 14 ausgestanzt. Im vorliegenden Fall werden aus einem Folienkörper insgesamt achtundvierzig Kartenkörper 14 ausgestanzt, von denen einer in der Figur 5 dargestellt ist. Das Ausstanzen des in der Figur 5 dargestellten Kartenkörpers 14 aus dem großflächigen Folienkörper 13 wird entlang der in der Figur 2 mit dem Bezugszeichen 6 bezeichneten strichpunktierten Linie vorgenommen.

Der Kartenkörper 14 ist von einer ersten Körperhauptfläche 15 und von einer zu der ersten Körperhauptfläche 15 parallelen zweiten Körperhauptfläche 16 begrenzt. In dem Kartenkörper 14 ist die Spule 2 eingebettet, wobei im vorliegenden Fall sowohl die Spulenwindungen 3 der Spule 2 als auch die beiden Spulenanschlusskontakte 4 und 5 der Spule 2 parallel zu den beiden Körperhauptflächen 15 und 16 verlaufend in den Kartenkörper 14 aufgenommen sind und in einem sich quer, in diesem Fall senkrecht zu der ersten Körperhauptfläche 15 und in diesem Fall auch zu der zweiten Körperhauptfläche 16 erstreckenden Windungsniveaubereich Z1 des Kartenkörpers 14 liegen. Im vorliegenden Fall liegt der Windungsniveaubereich Z1, in dem die Spule 2 liegt, in einem Abstand D1 von der zweiten Körperhauptfläche 16. Der Abstand D1 weist hierbei einen Wert von etwa 200 µm auf.

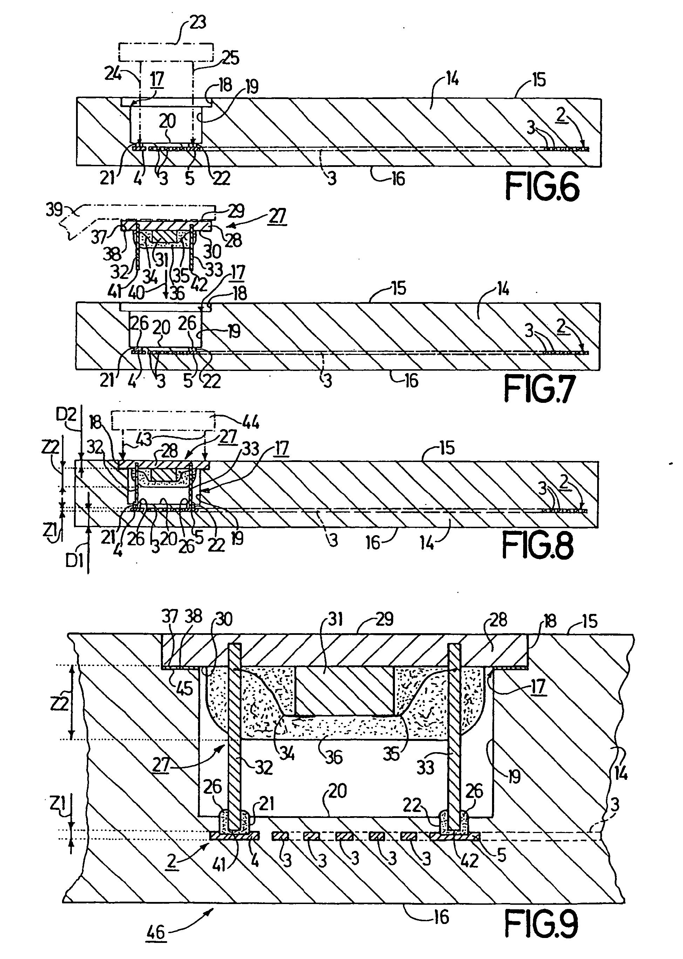

In einem nachfolgenden Verfahrensschritt wird mit einem Fräswerkzeug in einem Fräsvorgang in dem hergestellten Kartenkörper 14 durch Materialabtragung eine Ausnehmung 17 hergestellt, wie dies aus der Figur 6 ersichtlich ist. Bei dem vorerwähnten Fräsvorgang werden hierbei zwei Frässchritte durchgeführt, wodurch eine Ausnehmung 17 gebildet wird, die einen im Querschnitt größeren ersten Ausnehmungsbereich 18 und einen im Querschnitt kleineren zweiten Ausnehmungsbereich 19 aufweist. Die Ausnehmung 17 mündet - wie aus der Figur 6 ersichtlich - in die erste Körperhauptfläche 15.

In dem von der ersten Körperhauptfläche 15 abgewandten Bodenbereich, und zwar im Bereich einer Bodenfläche 20 der Ausnehmung 17, werden zwei von der Ausnehmung 17 bis zu den Spulenanschlusskontakten 4 und 5 reichende Zugänge 21 und 22 hergestellt. Die beiden Zugänge 21 und 22 werden in einem dritten Frässchritt und in einem vierten Frässchritt des vorerwähnten Fräsvorganges hergestellt.

In einem nachfolgenden Verfahrensschritt wird durch die Ausnehmung 17 und durch die beiden Zugänge 21 und 22 hindurch mit den beiden Spulenanschlusskontakten 4 und 5 der Spule 2 eine in der Figur 6 schematisch mit einer strichpunktierten Linie angedeutete Prüfeinrichtung 23 zum Prüfen der einwandfreien Funktionstüchtigkeit der Spule 2 in Wirkverbindung gebracht. Dies erfolgt in der Weise, dass zwei in der Figur 6 schematisch je mit einem strichpunktierten Pfeil dargestellte Prilfkontakte 24 und 25 der Prüfeinrichtung 23 mit den beiden Spulenanschlusskontakten 4 und 5 in leitende Verbindung gebracht werden. Mit der Prüfeinrichtung 23 ist die einwandfreie Funktionstüchtigkeit der Spule 2 feststellbar. Wenn mit der Prüfeinrichtung 23 eine fehlerhafte bzw. funktionsuntüchtige Spule 2 festgestellt wird, dann wird der betreffende Kartenkörper 14 samt der darin eingebetteten defekten Spule 2 ausgeschieden. Wenn mit der Prüfeinrichtung 23 ein positives Prüfergebnis hinsichtlich der einwandfreien Funktionstüchtigkeit der Spule 2 festgestellt wird, dann wird der betreffende Kartenkörper 14 samt der darin eingebetteten Spule 2 zum Herstellen einer Chipkarte weiterverwendet.

Bei einem weiteren Verfahrensschritt wird mit einer sogenannten Dispensereinrichtung in die beiden Zugänge 21 und 22 ein elektrisch leitendes Klebemittel 26 eingebracht, wie dies in der Figur 7 dargestellt ist.

Bereits vor dem Einbringen des elektrisch leitenden Klebemittels 26 in die beiden Zugänge 21 und 22 wird bei dem hier beschriebenen Verfahren ein sogenannter Modul in Bearbeitung genommen. Ein solcher Modul 27 ist in der Figur 7 schematisch dargestellt.

Der Modul 27 weist einen plattenförmigen Träger 28 auf. Der Träger 28 ist von einer ersten Trägerhauptfläche 29 und von einer zu der ersten Trägerhauptfläche 29 parallelen zweiten Trägerhauptfläche 30 begrenzt. Die Flächenabmessungen des Trägers 28 stimmen mit den Querschnittsabmessungen des ersten Ausnehmungsbereiches 18 im wesentlichen überein bzw. sind sie nur geringfügig kleiner. Die Umrisskonturen des ersten Ausnehmungsbereiches 18 und des Trägers 28 entsprechen dem in der Figur 2 mit der strichpunktierten Linie 7 dargestellten Verlauf.

Der Modul 27 weist weiters einen Chip 31 als Bauteil auf, bei dem es sich in bekannter Weise um einen integrierten Baustein handelt. Der Chip 31 ist mit dem Träger 28 verbunden, und zwar an der zweiten Trägerhauptfläche 30 des Trägers 28 beispielsweise mit einer Klebeverbindung. Wie aus der Figur 7 ersichtlich ist, ist somit der Chip 31 gegenüber der zweiten Trägerhauptfläche 30 erhaben.

Weiters weist der Modul 27 zwei mit dem Träger 28 verbundene, im Bereich der zweiten Trägerhauptfläche 30 sich befindende, zum Zusammenwirken mit den beiden Spulenanschlusskontakten 4 und 5 vorgesehene Modulanschlusskontakte 32 und 33 auf. Die beiden Modulanschlusskontakte 32 und 33 sind hierbei stiftförmig ausgebildet und in den Träger 28 eingesetzt, von dessen zweiter Trägerhauptfläche 30 die beiden stiftförmigen Modulanschlusskontakte 32 und 33 in diesem Fall senkrecht abstehen. Die beiden Modulanschlusskontakte 32 und 33 sind - was in der Figur 7 nur schematisch dargestellt ist - über je einen sogenannten Bonddraht 34 und 35 mit in der Figur 7 nicht dargestellten Chipanschlusskontakten des Chips 31 elektrisch leitend verbunden, die in Fachkreisen häufig als Pads bezeichnet werden. In der tatsächlichen Realität sind die stiftförmigen Modulanschlusskontakte 32 und 33 mit zwei im Bereich der zweiten Trägerhauptfläche 30 des Trägers 28 an dem Träger 28 vorgesehenen, jedoch nicht dargestellten Leiterbahnen elektrisch leitend verbunden, und ist jeder der beiden Bonddrähte 34 und 35 mit einer dieser beiden Leiterbahnen elektrisch leitend verbunden.

Zu erwähnen ist noch, dass der Chip 31 und die beiden Bonddrähte 34 und 35 sowie ein Teil der beiden Modulanschlusskontakte 32 und 33 in eine Umhüllung 36 eingebettet sind, die durch eine aus Kunstharz bestehende Vergussmasse gebildet ist.

Wie aus der Figur 7 ersichtlich ist, weisen bei dem vorliegenden Modul 27 die beiden Modulanschlusskontakte 32 und 33 eine besondere Ausbildung auf, nämlich dahingehend, dass die zum Zusammenwirken mit den beiden Spulenanschlusskontakten 4 und 5 vorgesehenen Modulanschlusskontakte 32 und 33 in einer senkrecht von der zweiten Trägerhauptfläche 30 weg weisenden Richtung den Chip 31 und im vorliegenden Fall auch die Umhüllung 36 niveaumäßig überragen.

Ein wie vorstehend beschriebener Modul 27 wird beispielsweise von einem Hersteller solcher Module in hoher Stückzahl angeliefert, wobei diese Module beispielsweise in einer sogenannten Gurtverpackung angeliefert werden.

Im Zuge des hier beschriebenen Verfahrens wird bei einem weiteren Verfahrensschritt in einem Randbereich 37 der zweiten Trägerhauptfläche 30 des Trägers 28 ein Heißschmelz-Klebemittel 38 aufgetragen, wie dies in der Figur 7 angedeutet ist.

Danach wird in einem weiteren Verfahrensschritt der Modul 27 mit Hilfe eines in der Figur 7 schematisch mit strichpunktierten Linien angedeuteten Bondarmes 39 mit dem Chip 31 und den beiden Modulanschlusskontakten 32 und 33 voran in Richtung des Pfeils 40 in die Ausnehmung 17 eingesetzt. Hierbei treten gegen Ende dieses Einsetzvorganges die beiden stiftförmigen Modulanschlusskontakte 32 und 33 mit ihren freien Enden 41 und 42 in die beiden mit dem elektrisch leitenden Klebemittel 26 gefüllten Zugänge 21 und 22 ein. Hierbei können je nach Toleranzverhältnissen die freien Enden 41 und 42 der beiden Modulanschlusskontakte 32 und 33 sogar unmittelbar bis zu den beiden Spulenanschlusskontakten 4 und 5 reichen. Im Regelfall wird aber zwischen den freien Enden 41 und 42 der Modulanschlusskontakte 32 und 33 und den Spulenanschlusskontakten 4 und 5 ein geringfügiger Abstand verbleiben, wie dies in der Figur 9 dargestellt ist. Beim Eindringen der freien Enden 41 und 42 der Modulanschlusskontakte 32 und 33 in die Zugänge 21 und 22 wird das elektrisch leitende Klebemittel 26 etwas aus den Zugängen 21 und 22 herausgedrückt, wie dies in den Figuren 8 und 9 dargestellt ist. Nach dem Einsetzen des Moduls 27 in die Ausnehmung 17 des Kartenkörpers 14 ist der in der Figur 8 dargestellte Verfahrensstand erhalten.

In einem weiteren Verfahrensschritt wird auf die erste Trägerhauptfläche 29 des Trägers 28 ein in der Figur 8 schematisch mit zwei Pfeilen angedeuteter Heizstempel 43 einer in der Figur 8 schematisch mit strichpunktierten Linien angedeuteten Heizvorrichtung 44 zum Aktivieren des Heißschmelz-Klebemittels 38 aufgesetzt. Danach wird von dem aufgesetzten Heizstempel 43 Hitze über den Träger 28 bis zu dem Heißschmelz-Klebemittel übertragen, wonach dann der Heizstempel 43 von dem Träger 28 wieder abgehoben wird. Beim nachfolgenden Abkühlen wird zwischen dem Randbereich 37 des Trägers 28 und der parallel zu den beiden Körperhauptflächen 15 und 16 verlaufenden ringförmigen Begrenzungsfläche 45 der Ausnehmung 17 eine Klebeverbindung gebildet, mit welcher der Modul 27 an dem Kartenkörper 14 festgehalten wird. Zum Festhalten des Moduls 27 an dem Kartenkörper 14 kann auch ein Klebemittel aus dem Gebiet der sogenannten Kaltklebetechnik zum Einsatz kommen.

Nach dem zuletzt beschriebenen Verfahrensschritt ist eine fertiggestellte Chipkarte 46 als Datenträger gemäß einem ersten Ausführungsbeispiel der Erfindung erhalten. Diese Chipkarte 46 ist ausschnittsweise in der Figur 9 dargestellt.

Durch das Einsetzen des Moduls 27 in die Ausnehmung 17 des Kartenkörpers 14 kommt die erste Trägerhauptfläche 29 des Trägers 28 der ersten Körperhauptfläche 15 des Kartenkörpers 14 zugewandt zu liegen, wobei im vorliegenden Fall die erste Trägerhauptfläche 29 mit der ersten Körperhauptfläche 15 fluchtet. Weiters kommt die zweite Trägerhauptfläche 30 des Trägers 28 von der ersten Körperhauptfläche 15 des Kartenkörpers 14 abgewandt und der zweiten Körperhauptfläche 16 des Kartenkörpers 14 zugewandt zu liegen. Weiters kommt der als Bauteil vorgesehene Chip 31 in einem sich quer, in diesem Fall senkrecht zu der ersten Körperhauptfläche 15 und in diesem Fall auch senkrecht zu der zweiten Körperhauptfläche 16 des Kartenkörpers 14 erstreckenden Bauteilniveaubereich Z2 des Kartenkörpers 14 zu liegen. Im vorliegenden Fall liegt der Bauteilniveaubereich Z2 in einem Abstand D2 von der ersten Körperhauptfläche 15. Der Abstand D2 weist hierbei einen Wert von etwa 100 µm auf. Im vorliegenden Fall, in dem der Chip 31 in einer Umhüllung 36 eingebettet ist, erstreckt sich der Bauteilniveaubereich Z2 des Kartenkörpers 14 über den gesamten Höhenbereich der Umhüllung 36. Für den Fall, dass ein Modul zum Einsatz kommt, bei dem der als Bauteil vorgesehene Chip von keiner Umhüllung umgeben ist bzw. bei dem die Umhüllung praktisch niveaugleich mit dem Chip ausgebildet ist, ist es ausreichend, wenn der Bauteilniveaubereich Z2 sich nur bis zu dem von der zweiten Trägerhauptfläche des Trägers abgewandten Endniveaubereich des Chips erstreckt.

Wie aus der Figur 9 ersichtlich ist, ist bei dem Datenträger 46 vorteilhafterweise die Ausbildung so getroffen, dass die Spulenwindungen 3 der Spule 2 und im vorliegenden Fall zusätzlich auch die beiden Spulenanschlusskontakte 4 und 5 der Spule 2 in einem außerhalb des Bauteilniveaubereiches Z2 liegenden Windungsniveaubereich Z1 liegen und dass die beiden Modulanschlusskontakte 32 und 33 über den Bauteilniveaubereich Z2 hindurch und im vorliegenden Fall auch über den Bauteilniveaubereich Z2 hinaus bis zu den beiden Spulenanschlusskontakten 4 und 5 reichen. Aufgrund dieser Ausbildung ist vorteilhafterweise erreicht, dass - trotzdem der Chip 31 und seine Umhüllung 36 und die beiden Modulanschlusskontakte 32 und 33 von derselben Trägerhauptfläche, nämlich der zweiten Trägerhauptfläche 30 des Trägers 28 des Moduls 27 abstehen - der Verlauf der Spulenwindungen 3 der Spule 2 und die Ausbildung der Spule 2 in der Umgebung des als Bauteil vorgesehenen Chips 31 keinen einschränkenden Einflüssen durch die Anwesenheit des Chips 31 unterliegen, weil der Chip 31 samt seiner Umhüllung 36 in einem gänzlich anderen Niveaubereich liegt als die Spulenwindungen 3 der Spule 2 und die beiden Spulenanschlusskontakte 4 und 5 der Spule 2. Wie aus der Figur 9 hierbei weiters ersichtlich ist, bedeutet die Tatsache, dass die beiden Modulanschlusskontakte 32 und 33 bis zu den beiden Spulenanschlusskontakten 4 und 5 reichen, nicht, dass die Modulanschlusskontakte 32 und 33 und die Spulenanschlusskontakte 4 und 5 sich unmittelbar berühren. Wie die Figur 9 zeigt, erfolgt bei dem Datenträger 46 sowohl die mechanische Verbindung zwischen den Modulanschlusskontakten 32 und 33 und den Spulenanschlusskontakten 4 und 5 als auch die elektrische Verbindung zwischen diesen Kontakten mit Hilfe des elektrisch leitenden Klebemittels 26, wodurch eine sichere und alterungsbeständige Verbindung zwischen den Modulanschlusskontakten 32 und 33 und den Spulenanschlusskontakten 4 und 5 gewährleistet ist. Wie aus der Figur 9 weiters ersichtlich ist, sind die beiden Spulenanschlusskontakte 4 und 5 beim Fräsen der beiden Zugänge 21 und 22 geringfügig angefräst worden, was aber keinerlei Nachteile mit sich bringt. Es könnten die beiden Spulenanschlusskontakte 4 und 5 ohne nachteilige Auswirkungen auf die elektrisch leitende Verbindung zwischen den Modulanschlusskontakten 32 und 33 und den Spulenanschlusskontakten 4 und 5 sogar zur Gänze durchfräst werden, weil das elektrisch leitende Klebemittel 26 die Durchfräsungen in den beiden Spulenanschlusskontakten 4 und 5 zur Gänze ausfüllen würde und auf diese Weise ebenso eine einwandfreie elektrische Verbindung zwischen den Modulanschlusskontakten 32 und 33 und den Spulenanschlusskontakten 4 und 5 geschaffen wäre.

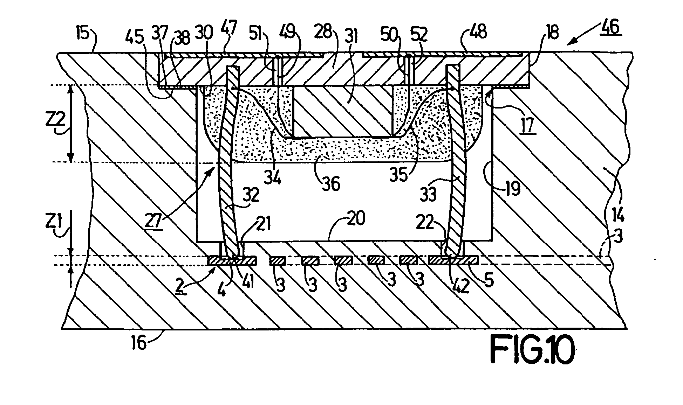

In der Figur 10 ist eine Chipkarte 46 als Datenträger gemäß einem zweiten Ausführungsbeispiel der Erfindung dargestellt. Bei dieser Chipkarte 46 weist der Modul 27 zwei elastisch nachgiebig ausgebildete Modulanschlusskontakte 32 und 33 auf, deren Länge nominal so gewählt ist, dass im fertiggestellten Zustand der Datenträger 46 gemäß der Figur 10 die beiden Modulanschlusskontakte 32 und 33 aufgrund ihrer elastischen Nachgiebigkeit verbogen sind und hierbei ausschließlich auf Basis ihrer elastischen Nachgiebigkeit mit den beiden Spulenanschlusskontakten 4 und 5 der Spule 2 in elektrisch leitender Verbindung stehen, so dass kein elektrisches leitendes Klebemittel zum Verbinden der Modulanschlusskontakte 32 und 33 und der Spulenanschlusskontakte 4 und 5 erforderlich ist und folglich eingespart werden kann.

Bei der Chipkarte 46 gemäß der Figur 10 sind mit dem Träger 28 des Moduls 27 im Bereich seiner ersten Trägerhauptfläche 29 vorgesehene weitere Modulanschlusskontakte verbunden, die zum Zusammenwirken mit von außerhalb der Chipkarte 46 mit ihnen in Kontaktverbindung bringbaren Gegenkontakten ausgebildet sind. Insgesamt sind bei der Chipkarte 46 gemäß der Figur 10 acht solcher weiterer Modulanschlusskontakte vorgesehen, von denen in der Figur 10 aber nur zwei weitere Modulanschlusskontakte 47 und 48 dargestellt sind. Die weiteren Modulanschlusskontakte sind - wie dies für die beiden weiteren Modulanschlusskontakte 47 und 48 aus der Figur 10 ersichtlich ist - über weitere Bonddrähte mit weiteren nicht dargestellten Chipanschlusskontakten (Pads) des Chips 31 verbunden, von denen in der Figur 10 die beiden weiteren Bonddrähte 49 und 50 dargestellt sind. Die weiteren Bonddrähte sind hierbei durch in dem Träger 28 vorgesehene Bohrungen hindurchgeführt, von denen in der Figur 10 zwei Bohrungen 51 und 52 dargestellt sind.

Bei dem als Bauteil vorgesehenen Chip 31 der Chipkarte 46 gemäß der Figur 10 handelt es sich um einen sogenannten Doppel-Zweck-Chip, dessen im Bereich der zweiten Trägerhauptfläche 30 vorgesehene Modulanschlusskontakte 32 und 33 mit den Spulenanschlusskontakten 4 und 5 der Spule 2 verbunden sind, die zum berührungslosen Datenaustausch zwischen dem Doppel-Zweck-Chip und einer Schreib/Lese-Station und gegebenenfalls zur berührungslosen Energieübertragung zu dem Doppel-Zweck-Chip vorgesehen ist, und dessen im Bereich der ersten Trägerhauptfläche 29 vorgesehene weitere Modulanschlusskontakte zum kontaktbehafteten Datenaustausch zwischen dem Doppel-Zweck-Chip und einer Schreib/Lese-Station und zur kontaktbehafteten Energieübertragung zu dem Doppel-Zweck-Chip vorgesehen sind.

Auch bei der Chipkarte 46 gemäß der Figur 10 liegen der als Bauteil vorgesehene Chip 31 samt seiner Umhüllung 36 und die Spule 2 mit ihren Spulenwindungen 3 und mit ihren beiden Spulenanschlusskontakten 4 und 5 in unterschiedlichen Niveaubereichen, nämlich der als Bauteil vorgesehene Chip 31 samt seiner Umhüllung 36 in dem Bauteilniveaubereich Z2 und die Spule 2 in dem Windungsniveaubereich Z1, was auch bei der Chipkarte 46 gemäß der Figur 10 den großen Vorteil bringt, dass - trotzdem der Chip 31 und seine Umhüllung 36 und die beiden Modulanschlusskontakte 32 und 33 von derselben Trägerhauptfläche, nämlich der zweiten Trägerhauptfläche 30 des Trägers 28 des Moduls 27 abstehen - der Verlauf der Spulenwindungen 3 der Spule 2 und die Ausbildung der Spule 2 in der Umgebung des Chips 31 keinen einschränkenden Einflüssen durch die Anwesenheit des Chips 31 unterliegen.

Die Erfindung ist auf die vorstehend beschriebenen Ausführungsbeispiele nicht beschränkt. So können zum Anbringen einer Ausnehmung in dem Datenträgerkörper auch andere geeignete Techniken zur Anwendung kommen, beispielsweise Ätztechniken oder Lasertechniken. Auch stehen zum Herstellen der Spulen andere geeignete Techniken zur Verfügung, beispielsweise Ätztechniken. Auch können in einem Datenträgerkörper auch zwei oder mehr als zwei Spulen aufgenommen sein. Ein in einen Datenträger eingesetzter Modul muss nicht unbedingt nur einen Chip als Bauteil enthalten, sondern kann auch einen Kondensator oder einen druckempfindlichen Folienschalter und dergleichen als Bauteil aufweisen. Erwähnt sei weiters noch, dass in einer einen erfindungsgemäßen Datenträger bildenden Chipkarte gegebenenfalls nicht nur ein einziger Chip als Bauteil, sondern auch zwei oder mehrere Chips enthalten sein können. Beispielsweise können in einer Chipkarte auch zwei Module mit je einem Chip oder auch ein Modul mit zwei Chips zum Einsatz kommen. Bei den vorstehend beschriebenen Ausführungsbeispielen sind die Träger der Module im Bereich der ersten Körperhauptfläche der Kartenkörper zugänglich, wobei die erste Trägerhauptfläche und die erste Körperhauptfläche bei den Chipkarten gemäß den zwei vorstehend beschriebenen Ausführungsbeispielen fluchten; es kann aber bei einer Chipkarte auch vorgesehen sein, dass die erste Trägerhauptfläche des Trägers eines Moduls von einer Abdeckschicht abgedeckt ist, wobei dann die äußere Begrenzungsfläche dieser Abdeckschicht mit der ersten Körperhauptfläche des Kartenkörpers dieser Chipkarte fluchtet. Bei den vorstehend beschriebenen Ausführungsbeispielen liegen je ein Modulanschlusskontakt und ein Spulenanschlusskontakt in einer genau senkrecht zu den Körperhauptflächen und genau senkrecht zu den Trägerhauptflächen verlaufenden Richtung einander gegenüber; dies muss aber nicht so sein, sondern ein Modulanschlusskontakt und ein Spulenanschlusskontakt können auch in einer schräg zu den Körperhauptflächen und den Trägerhauptflächen verlaufenden Richtung einander gegenüberliegen, wobei dann der den Bauteilniveaubereich der Chipkarte durchsetzende Modulanschlusskontakt einen gegenüber den vorgenannten Hauptflächen geneigten Verlauf aufweist.

Es ist abschließend als wesentliches Faktum noch zu erwähnen, dass bei sämtlichen im Rahmen dieser Anmeldung beschriebenen Ausführungsbeispielen von Datenträgern die den Datenträgerkörper begrenzende besagte Körperfläche, in welche die Ausnehmung mündet, in die der Modul eingesetzt ist, eine von außen zugängliche Körperaußenfläche ist. Dies muss aber nicht so sein, weil bei Datenträgern gemäß den beschriebenen Ausführungsbeispielen nach dem Einbringen des Moduls auf die besagte Körperfläche auch noch eine Abdeckschicht, beispielsweise in Form einer Abdeckfolie, aufgebracht werden kann, die im Falle eines ausschließlich für einen kontaktlosen Betrieb in einem Datenträger vorgesehenen Moduls diesen Modul zur Gänze abdecken kann und die im Fall eines für einen kontaktbehafteten Betrieb in einem Datenträger vorgesehenen Moduls diesen Modul zumindest unter teilweiser Freistellung der weiteren Modulanschlusskontakte zum Zusammenwirken mit Kontaktstiften einer Schreib/LeseEinrichtung abdecken kann, einen solchen Modul aber auch gar nicht abdecken kann, sondern nur die besagte Körperfläche. Bei einer derartigen Ausbildung ist die Körperaußenfläche des Datenträgerkörpers eines Datenträgers durch die Außenfläche der Abdeckschicht gebildet.

## Patentansprüche

1. Datenträger (46) mit einem Datenträgerkörper (14), der von einer Körperfläche (15) begrenzt ist und in den ein Modul (27) und eine gegenüber dem Modul (27) separate, Spulenwindungen (3) und mindestens zwei Spulenanschlusskontakte (4, 5) aufweisende Spule (2) aufgenommen ist, wobei der Modul (27) einen plattenförmigen Träger (28), der im wesentlichen parallel zu der besagten Körperfläche (15) verläuft und der von einer der besagten Körperfläche (15) zugewandten ersten Trägerhauptfläche (29) und von einer von der besagten Körperfläche (15) abgewandten und zu der ersten Trägerhauptfläche (29) im wesentlichen parallelen zweiten Trägerhauptfläche (30) begrenzt ist, und mindestens einen Bauteil (31), der in den Datenträgerkörper (14) aufgenommen und mit dem Träger (28) verbunden und gegenüber der zweiten Trägerhauptfläche (30) erhaben ist und der in einem sich quer zu der besagten Körperfläche (15) erstreckenden Bauteilniveaubereich (Z2) liegt, und mindestens zwei Modulanschlusskontakte (32, 33) aufweist, die mit dem Träger (28) verbunden und in dem Bereich der zweiten Trägerhauptfläche (30) vorgesehen sind, und wobei die Spulenwindungen (3) der Spule (2) zumindest in ihrem zu dem Bauteil (31) benachbarten Bereich in einem sich quer zu der besagten Körperfläche (15) erstreckenden, außerhalb des Bauteilniveaubereiches (Z2) liegenden Windungsniveaubereich (Z1) liegen und die Spulenanschlusskontakte (4, 5) gemeinsam mit den Spulenwindungen (3) der Spule (2) in dem Windungsniveaubereich (Z1) liegen, und wobei jeder Spulenanschlusskontakte (4, 5) in einer quer zu der zweiten Trägerhauptfläche (30) verlaufenden Richtung einem Modulanschlusskontakt (32, 33) gegenüberliegt und mit letzterem in elektrisch leitender Verbindung steht und wobei die Modulanschlusskontakte (32, 33) den Bauteil (31) niveaumäßig überragen und durch den Bauteilniveaubereich (Z2) hindurch bis zu den in dem Windungsniveaubereich (Z1) liegenden Spulenanschlusskontakten (4, 5) reichen und wobei der Datenträgerkörper (14) eine Ausnehmung (17) aufweist, die in die besagte Körperfläche (15) mündet und in die der Modul (27) eingesetzt ist, wobei der Datenträgerkörper (14) aus mindestens zwei Folien (8, 9, 10, 11, 1, 12) mit einem Laminierverfahren hergestellt ist und wobei eine nach dem Laminieren durch ein Materialabtragungsverfahren hergestellte Ausnehmung (17) vorgesehen ist und wobei in einem von der besagten Körperfläche (15) abgewandten Bodenbereich (20) der Ausnehmung (17) mindestens zwei ebenso nach dem Laminieren durch ein, vorzugsweise dasselbe Materialabtragungsverfahren hergestellte, von dem Bodenbereich (20) der Ausnehmung (17) bis zu den Spulenanschlusskontakten (4, 5) reichende Zugänge (21, 22) vorgesehen sind, durch die hindurch die Modulanschlusskontakte (32, 33) mit den Spulenanschlusskontakten (4, 5) in elektrisch leitender Verbindung stehen.

2. Datenträger (46) nach Anspruch 1, **dadurch gekennzeichnet, dass** in den Zugängen (21, 22) ein elektrisch leitendes Klebemittel (26) vorgesehen ist, mit dem die Modulanschlusskontakte (32, 33) und die Spulenanschlusskontakte (4, 5) elektrisch leitend miteinander verbunden sind.

3. Datenträger (46) nach einem der Ansprüche 1 bis 2, **dadurch gekennzeichnet, dass** die Spulenwindungen (3) und die Spulenanschlusskontakte (4,5) der Spule (2) durch mit einem Siebdruckverfahren hergestellte Leiterbahnen gebildet sind.

4. Datenträger (46) nach Anspruch 3, **dadurch gekennzeichnet, dass** die Spulenwindungen (3) und die Spulenanschlusskontakte (4, 5) der Spule (2) durch mit einem Siebdruckverfahren unter Verwendung einer Silberleitpaste hergestellte Leiterbahnen gebildet sind.

5. Datenträger (46) nach einem der Ansprüche 1 bis 4, **dadurch gekennzeichnet, dass** mit dem Träger (28) des Moduls (27) im Bereich seiner ersten Trägerhauptfläche (29) vorgesehene weitere Modulanschlusskontakte (47, 48) verbunden sind, die zum Zusammenwirken mit von außerhalb des Datenträgers (46) mit ihnen in Kontaktverbindung bringbaren Gegenkontakten ausgebildet sind.

6. Verfahren zum Herstellen eines Datenträgers (46), bei dem ein Datenträgerkörper (14) hergestellt wird, der von einer Körperfläche (15) begrenzt ist, und bei dem beim Herstellen des Datenträgerkörpers (14) eine Spule (2), die Spulenwindungen (3) und mindestens zwei Spulenanschlusskontakte (4, 5) aufweist, in den Datenträgerkörper (14) aufgenommen wird, wobei die Spulenwindungen (3) zumindest in ihrem zu einem Bauteil (31) benachbarten Bereich in einem sich quer zu der besagten Körperfläche (15) erstreckenden, außerhalb eines Bauteilniveaubereichs (Z2) liegenden Windungsniveaubereich (Z1) und die Spulenanschlusskontakte (4, 5) gemeinsam mit den Spulenwindungen (3) der Spule (2) in dem Windungsniveaubereich (Z1) zu liegen kommen, und bei dem in den Datenträgerkörper (14) ein Modul (27) aufgenommen wird, der einen plattenförmigen, von einer ersten Trägerhauptfläche (29) und von einer zu der ersten Trägerhauptfläche (29) im wesentlichen parallelen zweiten Trägerhauptfläche (30) begrenzten Träger (28) und den mit dem Träger (28) verbundenen, gegenüber der zweiten Trägerhauptfläche (30) erhabenen Bauteil (31) und mindestens zwei mit dem Träger (28) verbundene, im Bereich der zweiten Trägerhauptfläche (30) vorgesehene Modulanschlusskontakte (32, 33) aufweist, wobei die erste Trägerhauptfläche (29) der besagten Körperfläche (15) zugewandt und die zweite Trägerhauptfläche (30) von der besagten Körperfläche (15) abgewandt zu liegen kommen und wobei der Bauteil (31) in dem sich quer zu der besagten Körperfläche (15) erstreckenden Bauteilniveaubereich (Z2) zu liegen kommt, und bei dem je ein Modulanschlusskontakt (32, 33) und je ein Spulenanschlusskontakt (4, 5) in einer quer zu der zweiten Trägerhauptfläche (30) verlaufenden Richtung einander gegenüberliegend zu liegen kommen und in elektrisch leitende Verbindung gebracht werden, und bei dem zum Aufnehmen in den Datenträgerkörper (14) ein Modul (27) verwendet wird, bei dem die Modulanschlusskontakte (32, 33) den Bauteil (31) des Moduls (27) niveaumäßig überragen, und die Modulanschlusskontakte (32, 33) durch den Bauteilniveaubereich (Z2) hindurch bis zu den in dem Windungsniveaubereich (Z1) liegenden Spulenanschlusskontakten (4, 5) gebracht werden und mit den Spulenanschlusskontakten (4, 5) in elektrisch leitende Verbindung gesetzt werden, und bei dem in dem Datenträgerkörper (14) eine Ausnehmung (17) hergestellt wird, die in die besagte Körperfläche (15) mündet, wobei bei Herstellten des Datenträgerkörpers (14) die Spulenwindungen (3) und die Spulenanschlusskontakte (4, 5) der Spule (2) auf eine Trägerfolie (1) aufgebracht werden und wobei danach die Trägerfolie (1) mit den auf ihr aufgebrachten Spulenwindungen (3) und Spulenanschlusskontakten (4, 5) der Spule (2) mit mindestens einer weiteren Folie (8, 9, 10, 11, 12) gestapelt wird, wobei die Spulenwindungen (3) und die Spulenanschlusskontakte (4, 5) der Spule (2) zwischen der Trägerfolie (1) und einer Deckfolie (11) zu liegen kommen, und wobei danach die gestapelten Folien (8, 9, 10, 11, 1, 12) durch einen Laminiervorgang zum Herstellen des Datenträgerkörpers (14) laminiert werden und wobei nach dem Laminieren in dem hergestellten Datenträgerkörper (14) mit einem Materialabtragungsverfahren die Ausnehmung (17) hergestellt wird, und wobei nach dem Laminieren in einem von der besagten Körperfläche (15) abgewandten Bodenbereich (20) der Ausnehmung (17) ebenso durch ein, vorzugsweise dasselbe Materialabtragungsverfahren mindestens zwei von dem Bodenbereich (20) der Ausnehmung (17) bis zu den Spulenanschlusskontakten (4, 5) reichende Zugänge (21, 22) hergestellt werden und wobei der Modul (27) mit dem Bauteil (31) und den Modulanschlusskontakten (32, 32) voran in die Ausnehmung (17) eingesetzt wird und wobei die Modulanschlusskontakte (32, 33) durch die Zugänge (21, 22) hindurch mit den Spulenanschlusskontakten (4, 5) in elektrisch leitende Verbindung gesetzt werden.

7. Verfahren nach Anspruch 6, **dadurch gekennzeichnet, dass** vor dem Einsetzen des Moduls (27) in die Ausnehmung (17) in die Zugänge (21, 22) ein elektrisch leitendes Klebemittel (26) eingebracht wird.

8. Verfahren nach einem der Ansprüche 6 bis 7, **dadurch gekennzeichnet, dass** vor dem Einsetzen des Moduls (27) in die Ausnehmung (17) in einem Randbereich (37) der zweiten Trägerhauptfläche (30) des Trägers (28) des Moduls (27) ein HeiBschmelz-Klebemittel (38) aufgetragen wird und dass nach dem Einsetzen des Moduls (27) in die Ausnehmung (17) auf die erste Trägerhauptfläche (29) des Trägers (28) des Moduls (27) ein Heizstempel (43) einer Heizvorrichtung (44) zum Aktivieren des Heißschmelz-Klebemittels (38) aufgesetzt wird.

9. Verfahren nach einem der Ansprüche 6 bis 8, **dadurch gekennzeichnet, dass** als Trägerfolie (1), auf welche die Spuleawindungen (3) und die Spulenanschlusskontakte (4, 5) der Spule (2) aufgebracht werden, eine aus Polycarbonat bestehende Folie verwendet wird.

10. Verfahren nach einem der Ansprüche 6 bis 9, **dadurch gekennzeichnet, dass** als Deckfolie (11), die beim Stapeln der Folien (8, 9,10,11, 1, 12) den Spulenwindungen (3) und den Spulenanschlusskontakten (4, 5) der Spule (2) unmittelbar gegenüberliegt, eine aus Polyvinylchlorid bestehende Folie verwendet wird.

11. Verfahren nach einem der Ansprüche 6 bis 10, **dadurch gekennzeichnet, dass** die Spulenwindungen (3) und die Spulenanschlusskontakte (4, 5) der Spule (2) durch Aufbringen eines leitfähigen Materials auf die Trägerfolie (1) in einem Siebdruckvorgang hergestellt werden.

12. Verfahren nach Anspruch 11, **dadurch gekennzeichnet, dass** die Spulenwindungen (3) und die Spulenanschlusskontakte (4, 5) der Spule (2) durch Aufbringen einer Silberleitpaste auf die Trägerfolie (1) in einem Siebdruckvorgang hergestellt werden.

## Claims

1. A data carrier (46) comprising a data carrier body (14) bounded by a body surface (15) and incorporating a module (27) and a coil (2), which coil (2) is separate from the module (27) and has coil turns (3) and at least two coil connecting contacts (4, 5), the module (27) comprising a plate-shaped carrier (28), which extends substantially parallel to said body surface (15) and which is bounded by a first carrier main surface (29) facing said body surface (15) and by a second carrier main surface (30) facing away from and substantially parallel to the first carrier main surface (29), and at least one component (31), which component (31) is incorporated in the data carrier body (14), is connected to the carrier (28) and is raised with respect to the second carrier main surface (30), and is disposed in a component level zone (Z2) which extends transversely to said body surface (15), and comprises at least two module connecting contacts (32, 33) connected to the carrier (28) and arranged in the area of the second carrier main surface (30), and the coil turns (3) of the coil (2), at least in their area adjacent to the component (31), being disposed in a turn level zone (Z1) which is situated outside the component level zone (Z2) and extends transversely to said body surface (15), the coil connecting contacts (4, 5) together with the coil turns (3) of the coil (2) being disposed in the turn level zone (Z1), and each coil connecting contact (4, 5) being disposed opposite a module connecting contact (32, 33) in a direction transverse to the second carrier main surface (30) and being connected to the last-mentioned connecting contact in an electrically conductive manner, and the module connecting contacts (32, 33) projecting beyond the level of the component (31) and extending through the component level zone (Z2) up to the coil connecting contacts (4, 5), which are disposed in the turn level zone (Z1), and the data carrier body (14) having a recess (17) which ends in said body surface (15) and which accommodates the module (27), where the data carrier body (14) has been manufactured from at least two foils (8, 9, 10, 11, 1, 12) by means of a lamination process, and where there has been provided a recess (17) formed by means of a material removal process after the lamination process, and where in a bottom area (20) of the recess (17), which bottom area (20) is facing away from said body surface (15), at least two passages (21, 22) also after the lamination process, extending from the bottom area (20) of the recess (17) up to the coil connecting contacts (4, 5), have been formed, preferably also by means of the same material removal process, through which passages (21, 22) the module connecting contacts (32, 33) are connected to the coil connecting contacts (4, 5) in an electrically conductive manner.

2. A data carrier (46) as claimed in claim 1, **characterized in that** an electrically conductive bonding agent (26) is disposed in the passages (21, 22) with which bonding agent (26) the module connecting contacts (32, 33) and the coil connecting contacts (4, 5) are connected to each other in an electrically conductive manner.

3. A data carrier (46) as claimed in any one of the claims 1 to 2, **characterized in that** the coil turns (3) and the coil connecting contacts (4, 5) of the coil (2) are constituted by conductor tracks formed by means of a screen-printing process.

4. A data carrier (46) as claimed in claim 3, **characterized in that** the coil turns (3) and the coil connecting contacts (4, 5) of the coil (2) are constituted by conductor tracks formed by means of a screen-printing process using a conductive silver paste.

5. A data carrier (46) as claimed in any one of the claims 1 to 4, **characterized in that** further module connecting contacts (47, 48) arranged in the area of the first carrier main surface (29) are connected to the carrier (28) of the module (27) and are adapted to cooperate with mating contacts with which they are engageable from outside the data carrier (46).

6. A method of manufacturing a data carrier (46), in which a data carrier body (14) is manufactured, which data carrier body (14) is bounded by a body surface (15) and in which during the manufacture of the data carrier body (14) a coil (2) having coil turns (3) and at least two coil connecting contacts (4, 5) is incorporated in the data carrier body (14), which coil turns (3), at least in their area adjacent to a component (31) are arranged in a turn level zone (Z1) which is situated outside a component level zone (Z2) of the component and extends transversely to said body surface (15), and the coil connecting contacts (4, 5) together with the coil turns (3) of the coil (2) are arranged in the turn level zone (Z1), and in which a module (27) is incorporated in the data carrier body (14), which module (27) comprises a plate-shaped carrier (28), which is bounded by a first carrier main surface (29) and by a second carrier main surface (30) substantially parallel to the first carrier main surface (29), and the component (31), which is connected to the carrier (28) and is raised with respect to the second carrier main surface (30), and at least two module connecting contacts (32, 33) connected to the carrier (28) and arranged in the area of the second carrier main surface (30), the first carrier main surface (29) then facing said body surface (15) and the second carrier main surface (30) facing away from said body surface (15) and the component (31) then being disposed in the component level zone (Z2) which extends transversely to said body surface (15), and each module connecting contact (32, 33) and each coil connecting contact (4, 5) then being disposed opposite one another in a direction transverse to the second carrier main surface (30) and being connected in an electrically conductive manner, and in which for incorporation in the data carrier body (14) a module (27) is used whose module connecting contacts (32, 33) project beyond the level of the component (31) of the module (27), and the module connecting contacts (32, 33) are passed through the component level zone (Z2) up to the coil connecting contacts (4, 5), which are disposed in the turn level zone (Z1), and are connected to the coil connecting contacts (4, 5) so as to form an electrically conductive connection, and in which a recess (17) which ends in said body surface (15) is formed in the data carrier body (14), wherein during the manufacture of the data carrier body (14) the coil turns (3) and the coil connecting contacts (4, 5) of the coil (2) are formed on a carrier foil (1) and subsequently the carrier foil (1), with the coil turns (3) and the coil connecting contacts (4, 5) of the coil (2) formed on it, is stacked with at least one further foil (8, 9, 10, 11, 12), the coil turns (3) and the coil connecting contacts (4, 5) of the coil (2) then being interposed between the carrier foil (1) and a cover foil (11), and subsequently the stacked foils (8, 9, 10, 11, 1, 12) are laminated by means of a lamination process in order to form the data carrier body (14) and after the lamination process the recess (17) is formed in the manufactured data carrier body (14) by means of a material removal process, and after the lamination process in a bottom area (20) of the recess (17), which bottom area (20) of the recess (17) is facing away from said body surface (15), at least two passages (21, 22) are formed preferably also by means of the same material removal process, and where the module (27) with the component (31) and the module connecting contacts (32, 33) is inserted up front into the recess (17) and which passages (21, 22) extend from the bottom area (20) of the recess (17) up to the coil connecting contacts (4, 5), and the module connecting contacts (32, 33) are connected to the coil connecting contacts (4, 5) through the passages (21, 22) so as to form an electrically conductive connection.

7. A method as claimed in claim 6, **characterized in that** an electrically conductive bonding agent (26) is introduced into the passages (21, 22) before the module (27) is mounted in the recess (17).

8. A method as claimed in any one of the claims 6 to 7, **characterized in that** before the module (27) is mounted in the recess (17) a hot-melt bonding agent (38) is applied in a peripheral area (37) of the second carrier main surface (30) of the carrier (28) of the module (27) and **in that** after the module (27) has been mounted in the recess (17) a heating die (43) of a heating device (44) is placed onto the first carrier main surface (29) of the carrier (28) of the module (27) in order to activate the hot-melt bonding agent (38).

9. A method as claimed in any one of the claims 6 to 8, **characterized in that** a polycarbonate foil is used as the carrier foil (1) on which the coil turns (3) and the coil connecting contacts (4, 5) of the coil (2) are formed.

10. A method as claimed in any one of the claims 6 to 9, **characterized in that** a polyvinyl chloride foil is used as the cover foil (11) which is directly opposite to the coil turns (3) and the coil connecting contacts (4, 5) of the coil (2) when the foils (8, 9, 10, 11, 1, 12) are stacked.

11. A method as claimed in any one of the claims 6 to 10, **characterized in that** the coil turns (3) and the coil connecting contacts (4, 5) of the coil (2) are formed by depositing a conductive material on the carrier foil (1) in a screen-printing process.

12. A method as claimed in claim 11, **characterized in that** the coil turns (3) and the coil connecting contacts (4, 5) of the coil (2) are formed by depositing a conductive silver paste on the carrier foil (1) in a screen-printing process.

## Revendications

1. Support de données (46) avec un corps de support de données (14) qui est délimité par une surface de corps (15) et dans lequel un module (27) et une bobine (2) séparée du module (27) et présentant des spires de bobine (3) et au moins deux contacts de connexion de bobine (4, 5) sont incorporés,
dans lequel le module (27) présente un support en forme de plaque (28), qui s'étend substantiellement en parallèle à ladite surface de corps (15) et qui est délimité par une première surface de support principale (29) tournée vers ladite surface de corps (15) et par une deuxième surface de support principale (30) détournée de ladite surface de corps (15) et substantiellement parallèle à la première surface de support principale (29), et au moins un composant (31) qui est incorporé dans le corps de support de données (14) et relié au support (28) et en relief par rapport à la deuxième surface de support principale (30) et qui se trouve dans une zone de niveau de composant (Z2) s'étendant transversalement à ladite surface de corps (15), et au moins deux contacts de connexion de module (32, 33) qui sont reliés au support (28) et prévus dans la zone de la deuxième surface de support principale (30), et
dans lequel les spires de bobine (3) de la bobine (2) se trouvent au moins dans leur zone adjacente au composant (31) dans une zone de niveau de spire (Z1) s'étendant transversalement à ladite surface de corps (15) et située en dehors de la zone de niveau de composant (Z2), et les contacts de connexion de bobine (4, 5) se trouvent en conjonction avec les spires de bobine (3) de la bobine (2) dans la zone de niveau de spire (Z1), et
dans lequel chacun des contacts de connexion de bobine (4, 5), dans une direction s'étendant transversalement à la deuxième surface de support principale (30), fait face à un contact de connexion de module (32, 33) et se trouve en contact électriquement conducteur avec ce dernier, et
dans lequel les contacts de connexion de module (32, 33) dépassent le composant (31) en hauteur et atteignent à travers la zone de niveau de composant (Z2) les contacts de connexion de bobine (4, 5) situés dans la zone de niveau de spire (Z1), et
dans lequel le corps de support de données (14) présente un évidement (17) qui débouche sur ladite surface de corps (15) et dans lequel est inséré le module (27),
dans lequel le corps de support de données (14) est réalisé à partir d'au moins deux films (8, 9, 10, 11, 1, 12) par un procédé de laminage, et
dans lequel un évidement (17) fabriqué après laminage par un procédé d'enlèvement de matière est prévu, et
dans lequel, dans une zone de fond (20) de l'évidement (17), éloignée de ladite surface de corps (15), au moins deux accès (21, 22) sont prévus, également fabriqués après laminage par un procédé d'enlèvement de matière, de préférence par le même procédé, et allant de la zone de fond (20) de l'évidement (17) jusqu'aux contacts de connexion de bobine (4, 5), les contacts de connexion de module (32, 33) se trouvant en liaison électriquement conductrice avec les contacts de connexion de bobine (4, 5) à travers lesdits accès (21,22).

2. Support de données (46) selon la revendication 1, **caractérisé en ce que** dans les accès (21, 22), un agent adhésif électriquement conducteur (26) est prévu par lequel les contacts de connexion de module (32, 33) et les contacts de connexion de bobine (4, 5) sont reliés ensemble de façon électriquement conductrice.

3. Support de données (46) selon l'une quelconque des revendications 1 à 2, **caractérisé en ce que** les spires de bobine (3) et les contacts de connexion de bobine (4, 5) de la bobine (2) sont formés par des pistes conductives fabriquées par un procédé de sérigraphie.

4. Support de données (46) selon la revendication 3, **caractérisé en ce que** les spires de bobine (3) et les contacts de connexion de bobine (4, 5) de la bobine (2) sont formés par des pistes conductives fabriquées par un procédé de sérigraphie en utilisant une pâte d'argent conductrice.

5. Support de données (46) selon l'une quelconque des revendications 1 à 4, **caractérisé en ce que** des contacts de connexion de module (47, 48) supplémentaires sont reliés au support (28) du module (27) dans la zone de sa première surface de support principale (29), lesdits contacts étant réalisés pour coopérer avec des contacts complémentaires pouvant être amenés en liaison de contact avec ceux-ci depuis l'extérieur du support de données (46).

6. Procédé de fabrication d'un support de données (46),
dans lequel un corps de support de données (14) est fabriqué qui est délimité par une surface de corps (15), et
dans lequel, lors de la fabrication du corps de support de données (14), une bobine (2) qui présente des spires de bobine (3) et au moins deux contacts de connexion de bobine (4, 5), est reçue dans le corps de support de données (14), les spires de bobine (3) se retrouvant, au moins dans leur zone adjacente à un composant (31), dans une zone de niveau de spire (Z1) s'étendant transversalement à ladite surface de corps (15) et située en dehors d'une zone de niveau de composant (Z2), et les contacts de connexion de bobine (4, 5) se retrouvant en conjonction avec les spires de bobine (3) de la bobine (2) dans la zone de niveau de spire (Z1), et
dans lequel un module (27) est incorporé dans le corps de support de données (14), lequel présente un support en forme de plaque (28), qui est délimité par une première surface de support principale (29) et par une deuxième surface de support principale (30) substantiellement parallèle à la première surface de support principale (29), et le composant (31) relié au support (28) et en relief par rapport à la deuxième surface de support principale (30), et au moins deux contacts de connexion de module (32, 33) reliés au support (28) et prévus dans la zone de la deuxième surface de support principale (30),
dans lequel la première surface de support principale (29) se retrouve tournée vers ladite surface de corps (15) et la deuxième surface de support principale (30) se retrouve éloignée de ladite surface de corps (15), et
dans lequel le composant (31) se retrouve dans la zone de niveau de composant (Z2) s'étendant transversalement à ladite surface de corps (15), et
dans lequel respectivement un contact de connexion de module (32, 33) et un contact de connexion de bobine (4, 5) se retrouvent l'un en face de l'autre dans une direction s'étendant transversalement à la deuxième surface de support principale (3) et sont mis en liaison électriquement conductrice, et
dans lequel, pour le logement dans le corps de support de données (14), un module (27) est utilisé, dans lequel les contacts de connexion de module (32, 33) dépassent le composant (31) du module (27) en hauteur, et les contacts de connexion de module (32, 33) sont amenés à travers la zone de niveau de composant (Z2) jusqu'aux contacts de connexion de bobine (4, 5) situés dans la zone de niveau de spire (Z1) et sont mis en liaison électriquement conductrice avec les contacts de connexion de bobine (4, 5), et
dans lequel un évidement (17) est fabriqué dans le corps de support de données (14), débouchant sur ladite surface de corps (15),
dans lequel, lors de la fabrication du corps de support de données (14), les spires de bobine (3) et les contacts de connexion de bobine (4, 5) de la bobine (2) sont appliqués sur un film support (1), et
dans lequel, ensuite, le film support (1) avec les spires de bobine (3) et les contacts de connexion de bobine (4, 5) de la bobine (2), appliqués sur celui-ci, est empilé avec au moins un autre film (8, 9, 10, 11, 12), les spires de bobine (3) et les contacts de connexion de bobine (4, 5) de la bobine (2) se retrouvant entre le film support (1) et un film de recouvrement (11), et
dans lequel, ensuite, les films empilés (8, 9, 10, 11, 1, 12) sont laminés par une opération de laminage pour la fabrication du corps de support de données (14), et
dans lequel, après le laminage, dans le corps de support de données (14) fabriqué, un évidement (17) est fabriqué par un procédé d'enlèvement de matière, et
dans lequel, après le laminage, dans une zone de fond (20) de l'évidement (17), détournée de ladite surface de corps (15), au moins deux accès (21, 22) sont fabriqués également par un procédé d'enlèvement de matière, de préférence par le même procédé, lesdits accès allant de la zone de fond (20) de l'évidement (17) jusqu'aux contacts de connexion de bobine (4, 5), et
dans lequel le module (27), le composant (31) et les contacts de connexion de module (32, 32) étant orientés vers l'avant, est inséré dans l'évidement (17), et
dans lequel les contacts de connexion de module (32, 33) sont mis en liaison électriquement conductrice avec les contacts de connexion de bobine (4, 5) à travers les accès (21, 22).

7. Procédé selon la revendication 6, **caractérisé en ce qu'**avant l'insertion du module (27) dans l'évidement (17), un agent adhésif (26) électriquement conducteur est introduit dans les accès (21, 22).

8. Procédé selon l'une quelconque des revendications 6 à 7, **caractérisé en ce qu'**avant l'insertion du module (27) dans l'évidement (17), dans une zone de bord (37) de la deuxième surface de support principale (30) du support (28) du module (27), un agent adhésif thermofusible (38) est appliqué, et **en ce qu'**après l'insertion du module (27) dans l'évidement (17), sur la première surface de support principale (29) du support (28) du module (27), un poinçon chauffant (43) d'un dispositif de chauffage (44) est posé pour activer l'agent adhésif thermofusible (38).

9. Procédé selon l'une quelconque des revendications 6 à 8, **caractérisé en ce que** comme film support (1), sur lequel les spires de bobine (3) et les contacts de connexion de bobine (4, 5) de la bobine (2) sont appliqués, un film composé de polycarbonate est utilisé.

10. Procédé selon l'une quelconque des revendications 6 à 9, **caractérisé en ce que** comme film de recouvrement (11), qui lors de l'empilement des films (8, 9, 10, 11, 12) fait directement face aux spires de bobine (3) et aux contacts de connexion de bobine (4, 5) de la bobine (2), un film composé de polychlorure de vinyle est utilisé.

11. Procédé selon l'une quelconque des revendications 6 à 10, **caractérisé en ce que** les spires de bobine (3) et les contacts de connexion de bobine (4, 5) de la bobine (2) sont fabriqués par application d'un matériau conducteur sur le film support (1) au cours d'une opération de sérigraphie.

12. Procédé selon la revendication 11, **caractérisé en ce que** les spires de bobine (3) et les contacts de connexion de bobine (4, 5) de la bobine (2) sont fabriqués par application d'une pâte d'argent conductrice sur le film support (1) au cours d'une opération de sérigraphie.
